# EUROPÄISCHE PATENTANMELDUNG

(11) **EP 4 753 377 A1**
(43) Veröffentlichungstag der Anmeldung: **03.06.2026**
(21) Anmeldenummer: 24215839.2
(22) Anmeldetag: 27.11.2024
(51) Int. Cl.: H05K 1/02, H05K 1/11, F21Y 115/10, H05K 1/18, H05K 3/40, H05K 3/42

(54) **LEUCHTE ZUR BILDUNG EINES LICHTBANDES**

(71) Anmelder: Siteco GmbH, 83301 Traunreut (DE)
(72) Erfinder: Frank, Andreas, 83377 Vachendorf (DE); Wuppinger, Bernhard, 83362 Surberg (DE); Wimmer, Kilian, 83362 Surberg (DE)
(74) Vertreter: Schmidt, Steffen

(57) **Zusammenfassung**

Die Erfindung betrifft eine Leuchte, welche zur Bildung eines Lichtbandes eingerichtet ist, aufweisend: eine Leiterplatte mit mehreren elektrischen Leiterbahnen in wenigsten einer innenliegenden Schicht der Leiterplatte; LEDs, welche Leuchtmittel der Leuchte bilden, auf einer Oberfläche der Leiterplatte; wenigstens einen LED-Treiber zur elektrischen Stromversorgung der LEDs, wobei der LED-Treiber auf einer der mit den LEDs besetzten Oberfläche entgegengesetzten Oberfläche der Leiterplatte angeordnet ist; und Versorgungsleitungen zur Stromversorgung des LED-Treibers, wobei die Versorgungsleitungen durch die Leiterbahnen in der wenigstens einen innenliegenden Schicht der Leiterplatte zwischen der mit den LEDs besetzten Oberfläche und der mit dem LED-Treiber besetzten Oberfläche gebildet sind; wobei die Versorgungsleitungen mittels Durchgangskontaktierungen durch die Leiterplatte mit dem LED-Treiber elektrisch verbunden sind, und die Versorgungsleitungen an elektrischen Kontaktstellen der Leuchte mit Versorgungsleitungen einer benachbarten Leuchte elektrisch verbindbar sind.

## Beschreibung

Die vorliegende Erfindung bezieht sich auf eine Leuchte zur Bildung eines Lichtbandes und insbesondere auf eine Leuchte, die eine Leiterplatte mit innenliegenden elektrischen Leiterbahnen, LEDs auf einer Oberfläche der Leiterplatte, und einen LED-Treiber auf der gegenüberliegenden Oberfläche umfasst.

Im Bereich der Beleuchtungssysteme zur Bildung von Lichtbändern ist es üblich, Schienensysteme zu verwenden, die eine Durchgangsverdrahtung aufweisen. Diese Systeme ermöglichen es, Leuchteneinsätze in die Schienen einzustecken, wodurch eine flexible und modulare Beleuchtungslösung geschaffen wird. Solche Schienensysteme sind weit verbreitet und bieten den Vorteil, dass sie einfach zu installieren und zu warten sind. Die Durchgangsverdrahtung in diesen Systemen sorgt dafür, dass der elektrische Strom durch die gesamte Länge der Schiene fließen kann, wodurch mehrere Leuchten gleichzeitig betrieben werden können. Bekannte Systeme umfassen typischerweise mechanische und elektrische Verbindungen, die es ermöglichen, die Leuchteneinsätze sicher in der Schiene zu befestigen und mit Strom zu versorgen.

Trotz der weit verbreiteten Nutzung solcher Schienensysteme gibt es jedoch auch Nachteile, insbesondere im Hinblick auf die offenliegende Durchgangsverdrahtung. Diese kann anfällig für mechanische Beschädigungen sein, was die Zuverlässigkeit und Sicherheit des gesamten Systems beeinträchtigen kann. Darüber hinaus kann die Installation und Wartung solcher Systeme zeitaufwändig und komplex sein, insbesondere wenn Anpassungen oder Erweiterungen erforderlich sind. Die Flexibilität der Systeme ist oft durch die physische Struktur der Schienen begrenzt, was die Anpassungsfähigkeit an unterschiedliche räumliche Gegebenheiten einschränken kann.

Es ist daher ein der vorliegenden Erfindung zugrunde liegendes technisches Problem, ein Beleuchtungssystem bereitzustellen, das die Nachteile bekannter Systeme zumindest teilweise überwindet.

Es ist ein Ziel der vorliegenden Erfindung, eine Leuchte zur Bildung eines Lichtbandsystem bereitzustellen, welche die Nachteile der bekannten Lichtbandsysteme, insbesondere die Nachteile bekannter Schienensysteme zur Bildung solcher Lichtbänder überwindet.

Die Erfindung, löst die Aufgabe durch eine Leuchte nach Anspruch 1, die zur Bildung eines Lichtbandes eingerichtet ist. Diese Leuchte weist eine Leiterplatte mit mehreren elektrischen Leiterbahnen in wenigstens einer innenliegenden Schicht der Leiterplatte auf. LEDs, welche die Leuchtmittel der Leuchte bilden, sind auf einer Oberfläche der Leiterplatte angeordnet. Wenigstens ein LED-Treiber zur elektrischen Stromversorgung der LEDs ist auf einer der mit den LEDs besetzten Oberfläche entgegengesetzten Oberfläche der Leiterplatte angeordnet. Versorgungsleitungen zur Stromversorgung des LED-Treibers sind durch die Leiterbahnen in der wenigstens einen innenliegenden Schicht der Leiterplatte zwischen der mit den LEDs besetzten Oberfläche und der mit dem Treiber besetzten Oberfläche gebildet. Die Versorgungsleitungen sind mittels Durchgangskontaktierungen durch die Leiterplatte mit dem LED-Treiber elektrisch verbunden. Die Versorgungsleitungen sind an elektrischen Kontaktstellen der Leuchte mit Versorgungsleitungen einer benachbarten Leuchte elektrisch verbindbar.

Eine Besonderheit der erfindungsgemäßen Lösung ist die Integration der Versorgungsleitungen in die eine oder mehrere innenliegenden Schichten einer mehrschichtigen Leiterplatte, welche die offenliegende Durchgangsverdrahtung in den Schienen herkömmlicher Schienensysteme ersetzten. Ein Vorteil dieser Anordnung ist eine signifikante Reduktion des Materialeinsatzes, da die herkömmliche Verdrahtung und die damit verbundenen Isolationsmaterialien entfallen. Dies führt zu einer Verringerung der Brandlast, was die Sicherheit erhöht. Ein weiterer Vorteil ist die Vereinfachung des Fertigungsverfahrens, da mehrere Prozessschritte entfallen, die sonst zur mechanischen und elektrischen Verbindung der verschiedenen Komponenten erforderlich wären. Dies reduziert nicht nur die Komplexität, sondern auch die Kosten für Produktionsanlagen und Prüfmittel. Die Ausfallsicherheit wird ebenfalls verbessert, da die Anzahl der Steckverbindungen minimiert wird, was die Wahrscheinlichkeit von Fehlern durch schlechte Verbindungen verringert. Schließlich bietet die Möglichkeit, die Versorgungsleitungen an elektrischen Kontaktstellen der Leuchte mit den Versorgungsleitungen einer benachbarten Leuchte zu verbinden, eine flexible und modulare Erweiterung des Lichtbandsystems. Dies erleichtert die Installation und Wartung des Systems erheblich und ermöglicht eine nahtlose Integration zusätzlicher Leuchten, ohne dass umfangreiche Änderungen an der bestehenden Infrastruktur erforderlich sind. Insgesamt tragen diese Merkmale dazu bei, die Effizienz, Zuverlässigkeit und Flexibilität der Leuchte zu erhöhen, was sie zu einer attraktiven Lösung für moderne Lichtbandsysteme macht.

Nach einer Ausführungsform umfasst die Leuchte eine oder mehrere Versorgungsleitungen mit einem Leitungsquerschnitt von mindestens 2,5 mm² in einer oder mehreren innenliegenden Schichten der Leiterplatte. Diese spezifische Gestaltung der Versorgungsleitungen bietet eine höhere Stromtragfähigkeit, was besonders wichtig ist, um die einzelnen Leuchten im Lichtband effizient und zuverlässig mit Strom zu versorgen. Dies ist von besonderer Bedeutung in Lichtbandsystemen, die oft lange Strecken abdecken und daher eine stabile und verlustarme Stromversorgung benötigen. Der größere Leitungsquerschnitt trägt zur Reduzierung des elektrischen Widerstands bei, was wiederum die Energieeffizienz der Leuchte verbessert. Dies ist ein wesentlicher Vorteil, da es den Energieverbrauch senkt und die Betriebskosten reduziert. Ein weiterer Vorteil kann die Verteilung der Versorgungsleitungen auf mehrere innenliegenden Schichten der Leiterplatte bieten. Die thermische Belastung verteilt sich gleichmäßiger, was zur Verlängerung der Lebensdauer der elektronischen Komponenten beiträgt. Durch die Verwendung von Durchgangskontaktierungen (Vias) zur elektrischen Verbindung der Versorgungsleitungen mit dem LED-Treiber wird zudem eine zuverlässige und stabile elektrische Verbindung gewährleistet. Diese Konstruktion minimiert das Risiko von Kontaktproblemen, die bei herkömmlichen Verdrahtungsmethoden auftreten können. Darüber hinaus ermöglicht die Integration der Versorgungsleitungen in die Leiterplatte eine kompaktere und robustere Bauweise der Leuchte, da externe Verdrahtungen und deren potenzielle Schwachstellen eliminiert werden. Dies führt zu einer höheren mechanischen Stabilität und verringert die Anfälligkeit für Beschädigungen durch äußere Einflüsse.

Eine bemerkenswerte Eigenschaft einer Ausführungsform der Leuchte ist die Schichtdicke der Versorgungsleitungen, die mindestens 400 µm entlang einer Richtung senkrecht zu den mit den LEDs besetzten und den mit dem LED-Treiber besetzten Oberflächen beträgt. Diese erhöhte Schichtdicke der Versorgungsleitungen ermöglicht eine verbesserte Stromtragfähigkeit, was bedeutet, dass die Leitungen in der Lage sind, größere Strommengen zu transportieren, ohne übermäßig zu erhitzen oder an Effizienz zu verlieren. Dies ist besonders wichtig in Lichtbandsystemen, wo mehrere Leuchten in Reihe geschaltet werden und eine konsistente Stromversorgung über die gesamte Länge des Lichtbandes gewährleistet sein muss. Zum anderen reduziert die erhöhte Schichtdicke die Notwendigkeit für zusätzliche Verdrahtung oder externe Leitungen, was den Materialeinsatz verringert und die Brandlast des Systems reduziert.

Anstelle einer Versorgungsleitung mit verhältnismäßig großem Querschnitt bzw. großer Schichtdicke kann wenigstens eine der Versorgungsleitungen auch auf mehrere innenliegende Schichten verteilt sein. Diese weisen jeweils eine Schichtstärke zwischen 20 µm und 200 µm auf, die in der Summe eine Gesamtdicke von mindestens 400 µm bilden. Diese Verteilung auf mehrere Schichten bietet Flexibilität in der Gestaltung der Leiterplatte und ermöglicht es, standardisierte mehrschichtige Leiterplatten einzusetzen. Die Verwendung mehrerer Schichten kann auch dazu beitragen, die mechanische Stabilität der Leiterplatte zu erhöhen.

Nach einer Ausführungsform ist die Leuchte mit einer oder zwei Stirnseiten der Leiterplatte ausgestattet, die über mehrpolige Steckverbinder verfügen. Diese Steckverbinder sind so eingerichtet, dass sie die elektrischen Kontaktstellen zwischen den Versorgungsleitungen der Leuchte und den Versorgungsleitungen einer benachbarten Leuchte bilden. Die Steckkontakte können dabei z.B. in THT (Through Hole Technology) oder SMT (Surface Mounted Technology) ausgeführt sein. THT und SMT sind zwei unterschiedliche Methoden zur Befestigung elektronischer Bauteile auf Leiterplatten. THT beinhaltet das Einführen von Bauteilanschlüssen durch Löcher in der Leiterplatte und deren anschließendes Verlöten, was eine robuste mechanische Verbindung schafft. SMT hingegen ermöglicht das direkte Auflöten der Bauteile auf die Oberfläche der Leiterplatte, was eine kompaktere Bauweise und eine höhere Automatisierung in der Fertigung erlaubt. Die Verwendung von mehrpoligen Steckverbindern an den Stirnseiten der Leiterplatte ermöglicht eine einfache und zuverlässige elektrische Verbindung zwischen benachbarten Leuchten, was die Installation und Wartung des Lichtbandes vereinfacht. Diese Steckverbinder sorgen dafür, dass die elektrischen Kontaktstellen sicher und stabil verbunden sind, was die Ausfallsicherheit erhöht und die elektrische Leitfähigkeit verbessert. Durch die Integration dieser Steckverbinder wird das Lichtbandsystem modularer und flexibler, da einzelne Leuchteneinheiten leicht hinzugefügt oder entfernt werden können, ohne dass umfangreiche Verdrahtungsarbeiten erforderlich sind. Dies reduziert den Material- und Arbeitsaufwand und minimiert die Fehleranfälligkeit bei der Installation. Darüber hinaus trägt die Verwendung von SMT oder THT zur mechanischen Stabilität der Verbindung bei, was insbesondere bei längeren Lichtbändern von Vorteil ist, da es die strukturelle Integrität des gesamten Systems unterstützt.

Nach einer Ausführungsform umfasst die Leuchte parallel zu den Versorgungsleitungen weitere Leiterbahnen in der wenigstens einen innenliegenden Schicht der Leiterplatte, die Steuerleitungen bilden. Diese Steuerleitungen sind zur Steuerung des LED-Treibers oder einer oder mehrerer der LEDs eingerichtet. Insbesondere können die Steuerleitungen durch DALI-Busleitungen gebildet sein. Die Steuerleitungen ermöglichen eine präzise Steuerung und Anpassung der Beleuchtung, was zu einer verbesserten Energieeffizienz und Flexibilität im Betrieb führt. Durch die Integration der Steuerleitungen in die Leiterplatte wird die Komplexität der Verdrahtung reduziert, was die Zuverlässigkeit erhöht und den Installationsaufwand verringert. Die Verwendung von DALI-Busleitungen bietet den Vorteil einer standardisierten, digitalen Schnittstelle, die eine einfache Integration in bestehende Beleuchtungssysteme ermöglicht und eine zentrale Steuerung mehrerer Leuchten erlaubt. Die parallele Anordnung der Steuerleitungen zu den Versorgungsleitungen innerhalb der Leiterplatte trägt zudem zur Platzersparnis und einer kompakteren Bauweise der Leuchte bei.

Nach einer Ausführungsform sind die Steuerleitungen der Leuchte mit Steuerleitungen einer benachbarten Leuchte verbindbar, insbesondere durch eine mehrpolige Steckverbindung an der Leiterplatte. Diese spezifische Verbindungsmethode ermöglicht eine einfache und zuverlässige elektrische Verbindung zwischen benachbarten Leuchten, was die Installation und Wartung des Lichtbandsystems erleichtert. Durch die Integration der Steuerleitungen in die Leiterplatte wird der Verkabelungsaufwand reduziert und die Gesamtkomplexität des Systems verringert.

Nach einer Ausführungsform umfasst die Leuchte auf der Oberfläche der Leiterplatte mindestens einen Signalverstärker, der speziell dafür ausgelegt ist, das Signal der Steuerleitungen zu verstärken. Dieser Signalverstärker spielt eine entscheidende Rolle bei der Verbesserung der Signalqualität und der Erhöhung der maximalen Schienenlänge, die das Lichtbandsystem unterstützen kann. In herkömmlichen Lichtbandsystemen kann die Signalübertragung über längere Distanzen zu einer Verschlechterung der Signalqualität führen, was die Funktionalität und Zuverlässigkeit des Systems beeinträchtigen kann. Durch die Integration eines Signalverstärkers auf der Leiterplatte wird dieses Problem adressiert, indem das Signal verstärkt wird, um eine klare und zuverlässige Kommunikation zwischen den Komponenten des Lichtbandsystems sicherzustellen. Der Signalverstärker kann auf der gleichen Oberfläche wie der LED-Treiber platziert werden, was eine kompakte Bauweise ermöglicht und den Platzbedarf minimiert. Diese Anordnung trägt auch zur Reduzierung des Materialeinsatzes und der Komplexität des Systems bei, da zusätzliche externe Signalverstärker oder komplizierte Verdrahtungen überflüssig werden. Die Integration des Signalverstärkers auf der Leiterplatte unterstützt auch die Modularität und Flexibilität des Lichtbandsystems, da die Leuchteneinheiten einfach miteinander verbunden werden können, ohne dass die Signalqualität beeinträchtigt wird. Dies ist besonders vorteilhaft in Anwendungen, bei denen eine nahtlose und endlose Verlängerung des Lichtbands erforderlich ist. Signalverstärker direkt auf der Leiterplatte zu integrieren, vereinfacht auch den Herstellungsprozess und reduziert die Notwendigkeit für zusätzliche Komponenten oder komplexe Verdrahtungslösungen.

Nach einer Ausführungsform umfasst die Leuchte mehrere versetzt zueinander angeordnete Lötpads auf wenigstens einer der Oberflächen der Leiterplatte. Diese Lötpads sind mittels Durchgangskontaktierungen mit den Versorgungsleitungen in der innenliegenden Schicht der Leiterplatte und/oder mit mindestens einer Signalleitung in einer innenliegenden Schicht der Leiterplatte elektrisch verbunden. Die Lötpads dienen als Kontaktpunkte für die elektrische Verbindung von Komponenten auf der Leiterplatte. Durch die versetzte Anordnung der Lötpads wird sichergestellt, dass die notwendigen Abstände eingehalten werden, um Kurzschlüsse zu vermeiden und die elektrische Isolation zu gewährleisten. Die in der wenigstens einen innenliegenden Schicht angeordneten Leiterbahnen können demgegenüber in engerem Abstand angeordnet sein, weil das Material der Leiterplatte eine bessere Isolation zwischen den Leiterbahnen gewährleistet. Ein weiterer Vorteil dieser Anordnung der Lötpads ist die erhöhte Flexibilität bei der Platzierung von Komponenten auf der Leiterplatte. Dies ermöglicht eine effiziente Nutzung des verfügbaren Platzes. Durch die Verwendung von Lötpads und Durchgangskontaktierungen wird auch die Herstellung und Montage der Leuchte vereinfacht, da diese Elemente automatisiert bestückt und verlötet werden können. Dies reduziert den manuellen Aufwand und die Fehleranfälligkeit während der Produktion.

Nach einer Ausführungsform, bei der die LEDs und/oder der LED-Treiber an ausgewählten Lötpads direkt angelötet sind, wird eine direkte und zuverlässige elektrische Verbindung zwischen den Komponenten und der Leiterplatte gewährleistet. Durch das direkte Anlöten der LEDs und des LED-Treibers an diese Lötpads wird die Notwendigkeit zusätzlicher Verbindungselemente oder -kabel eliminiert, was die Komplexität und die Anzahl der potenziellen Fehlerquellen reduziert. Ein Vorteil dieser Anordnung ist die verbesserte Wärmeableitung, da die Wärme direkt von den LEDs und dem LED-Treiber über die Lötpads auf die Leiterplatte übertragen wird, was die Lebensdauer und die Effizienz der LEDs erhöht. Zudem wird die räumliche Flexibilität bei der Positionierung der LEDs und des LED-Treibers bereitgestellt, da die Lötpads strategisch auf der Leiterplatte platziert werden können, um eine optimale Lichtverteilung und eine effiziente Nutzung des verfügbaren Platzes zu gewährleisten. Diese Flexibilität ermöglicht es, die LEDs in einem gleichmäßigen Abstand zu positionieren, was zu einer homogenen Lichtausbeute führt und Schattenbildung minimiert. Darüber hinaus kann der LED-Treiber auf der gegenüberliegenden Seite der Leiterplatte angeordnet werden, was eine kompakte Bauweise und eine bessere Trennung der Stromversorgungs- und Steuerungskomponenten ermöglicht.

Nach einer Ausführungsform umfasst die Leuchte LEDs, die in einem einheitlichen Abstand entlang wenigstens einer Längsrichtung der Leiterplatte bis zu zwei entgegengesetzten Rändern der Leiterplatte angeordnet sind. Die Abstände zu den Rändern der Leiterplatte sind so gewählt, dass die LED-Abstände zu einer benachbarten Leuchte gleicher Bauart kontinuierlich fortsetzbar sind. Dies bedeutet, dass die LEDs entlang der Leiterplatte gleichmäßig verteilt sind und die Abstände zwischen den LEDs und den Rändern der Leiterplatte so bemessen sind, dass bei der Aneinanderreihung mehrerer Leuchten ein durchgehendes und gleichmäßiges Lichtband entsteht. Diese Anordnung ermöglicht eine nahtlose Integration mehrerer Leuchten, wodurch ein kontinuierliches Lichtband ohne sichtbare Unterbrechungen oder dunkle Stellen geschaffen wird.

Weitere Merkmale und Vorteile der Erfindung werden aus der nachfolgenden Beschreibung bevorzugter Ausführungsformen deutlich, die in Verbindung mit den beigefügten Figuren gegeben wird. In den Figuren ist folgendes dargestellt:
- Figur 1a: zeigt einen Querschnitt durch eine erste Ausführungsform einer Leuchte mit versetzt angeordneten Lötpads und Durchkontaktierungen.
- Figur 1b: zeigt eine Teilaufsicht auf die Leuchte der Figur 1a mit Lötpads auf eine Oberseite der Leiterplatte.
- Figur 1c: zeigt eine Teilaufsicht auf Leuchte der Figuren 1a auf die mit LEDs besetzte Unterseite der Leiterplatte.
- Figur 2a: zeigt einen Querschnitt durch eine zweite Ausführungsform einer Leuchte mit durchkontaktierten Löchern zur Verbindung von Leiterbahnen und LEDs.
- Figur 2b: zeigt eine Teilaufsicht der Leuchte der Figur die mit LEDs besetzte Unterseite der Leiterplatte.

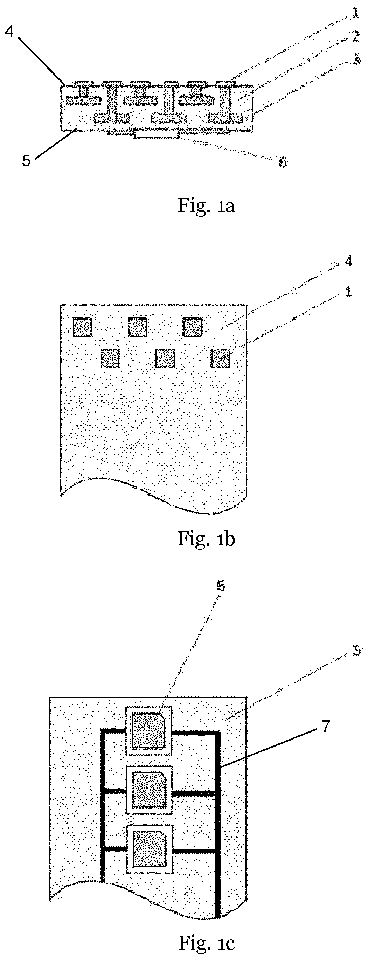

Figuren 1a bis 1c zeigt Ansichten einer ersten Ausführungsform einer Leuchte.

Figur 1a illustriert eine Querschnittsansicht der Leiterplatte einer ersten Ausführungsform der Leuchte. Lötpads 1 sind auf einer Oberseite 4 der Leiterplatte angeordnet. Diese Lötpads 1 sind zur Kontaktierung von SMT-Bauteilen vorgesehen. Die versetzte Anordnung der Lötpads 1 ermöglicht die Einhaltung der normativ erforderlichen Abstände zwischen den Leiterbahnen und Pads. Durchkontaktierungen 2 stellen die elektrische Verbindung von den Lötpads 1 zu innenliegenden Leiterbahnen 3 her. LEDs 6 sind auf der Unterseite 5 der Leiterplatte angeordnet. Die Leiterbahnen 3 sind in mehreren innenliegenden Schichten der Leiterplatte angeordnet und umfassen insbesondere die Leiterbahnen welche als Versorgungsleitungen zur Stromversorgung des LED-Treibers (in den Figuren nicht dargestellt) vorgesehen sind. LEDs 6 sind auf der Unterseite 5 der Leiterplatte angeordnet und in dieser Ausführungsform mit außenliegenden Leiterbahnen 7 auf der Unterseite 5 der Leiterplatte elektrisch verbunden.

Figur 1b zeigt eine Draufsicht auf die Oberseite 4 der Leiterplatte. Hier sind die Lötpads 1 zu sehen, die zur Kontaktierung von elektromechanischen SMT-Bauteilen vorgesehen sind. Diese Pads ermöglichen die elektrische und mechanische Verbindung benachbarter LED-Module auf der LED-abgewandten Seite. Auf der Unterseite 4 ist ferner der LED-Treiber angeordnet und elektrisch kontaktiert (im Ausschnitt der Figur 1b jedoch nicht zu sehen).

Figur 1c zeigt eine Draufsicht auf die Unterseite 5 der Leiterplatte. Die LEDs 6 sind auf dieser Oberfläche angeordnet und mit den Leiterbahnen 7 verbunden. Die Anordnung der LEDs 6 ermöglicht einen einheitlichen LED-Abstand über Modulgrenzen hinweg, d.h. bei einer stirnseitigen Verbindung der Leuchte mit einer weiteren baugleichen Leuchte (in den Figuren nicht dargestellt).

Die in den Figuren 1a bis 1c dargestellten Ausführungsformen zeigen die Integration von LEDs 6, Leiterbahnen 3 und Kontaktierungselementen auf einer mehrlagigen Leiterplatte. Die Durchkontaktierungen 2 ermöglichen die elektrische Verbindung zwischen den verschiedenen Schichten der Leiterplatte, während die Lötpads 1 und STM-Bauteile die mechanische und elektrische Verbindung benachbarter Module sicherstellen. Die Anordnung der LEDs 6 auf der Unterseite 4 der Leiterplatte ermöglicht eine gleichmäßige Lichtverteilung über die gesamte Länge des Lichtbandes.

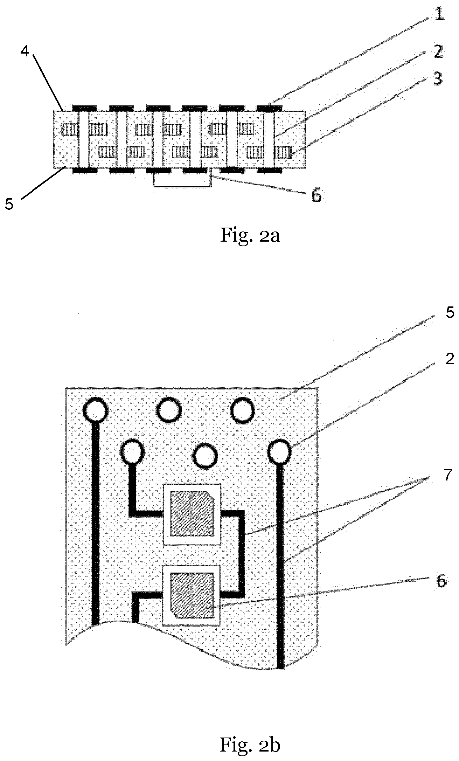

Die Figuren 2a und 2b zeigen eine weitere Ausführungsform einer Leuchte mit mehrlagiger Leiterplatte zur Verwendung in einem kombinierten elektronischen Lichtband. Diese Ausführungsform illustriert die Kontaktierung der innenliegenden Leiterbahnen 3 über durchkontaktierte Löcher 2 für THT (Through Hole Technology) Bauteile.

Figur 2a zeigt einen Querschnitt durch die mehrschichtige Leiterplatte, in der die Anordnung der verschiedenen Schichten und Komponenten dargestellt ist. Die Lötpads 1 befinden sich auf der Oberseite 4 der Leiterplatte und sind zur Kontaktierung von THT-Bauteilen vorgesehen. Die durchkontaktierten Löcher 2 stellen die elektrische Verbindung zwischen den Lötpads 1 und den innenliegenden Leiterbahnen 3 her. Die LEDs 6 sind auf der Unterseite 5 der Leiterplatte der montiert und durch die Leiterbahnen 7 elektrisch verbunden.

Figur 2b zeigt eine Draufsicht auf einen Abschnitt der mit den LEDs 6 besetzen Oberfläche (Unterseite 5) der Leiterplatte. Die durchkontaktierten Löcher 2 erstrecken sich auf die Unterseite 5 der Leiterplatte und sind mit Leiterbahnen 7 mit den LEDs 6 verbunden. Die durchkontaktierten Löcher 2 ermöglichen die elektrische Verbindung der Lötpads 1 und der Leiterbahnen 7 mit den innenliegenden Leiterbahnen 3. Diese Anordnung ermöglicht es, THT-Bauteile am stirnseitigen Rand des Leiterplatte zu montieren, um eine mechanische und elektrische Verbindung zwischen benachbarten PCBs herzustellen.

Insgesamt zeigt diese Ausführungsform eine durchdachte Integration von mechanischen und elektrischen Verbindungselementen, die zur Optimierung der Herstellung und des Betriebs von kombinierten elektronischen Lichtbandelementen beiträgt.

### Bezugszeichenliste

1 Lötpad
2 Durchgangskontaktierung
3 innenliegende Leiterbahn (insbesondere umfassend Versorgungsleitung und optional Steuerleitung)
4 Oberseite der Leiterplatte (mit LED-Treiber besetzte Oberfläche)
5 Unterseite der Leiterplatte (mit LEDs besetzte Oberfläche)
6 LED
7 Leiterbahn auf einer Oberfläche der Leiterplatte

## Patentansprüche

1. Leuchte, welche zur Bildung eines Lichtbandes eingerichtet ist, aufweisend:
eine Leiterplatte mit mehreren elektrischen Leiterbahnen (3) in wenigsten einer innenliegenden Schicht der Leiterplatte;
LEDs (6), welche Leuchtmittel der Leuchte bilden, auf einer Oberfläche (5) der Leiterplatte;
wenigstens einen LED-Treiber zur elektrischen Stromversorgung der LEDs (6), wobei der LED-Treiber auf einer der mit den LEDs (6) besetzten Oberfläche (5) entgegengesetzten Oberfläche (4) der Leiterplatte angeordnet ist; und
Versorgungsleitungen zur Stromversorgung des LED-Treibers, wobei die Versorgungsleitungen durch die Leiterbahnen (3) in der wenigstens einen innenliegenden Schicht der Leiterplatte zwischen der mit den LEDs (6) besetzten Oberfläche (5) und der mit dem LED-Treiber besetzten Oberfläche (4) gebildet sind;
wobei die Versorgungsleitungen mittels Durchgangskontaktierungen (2) durch die Leiterplatte mit dem LED-Treiber elektrisch verbunden sind, und
die Versorgungsleitungen an elektrischen Kontaktstellen der Leuchte mit Versorgungsleitungen einer benachbarten Leuchte elektrisch verbindbar sind.

2. Leuchte nach Anspruch 1, wobei wenigstens eine der Versorgungsleitungen einen Leitungsquerschnitt von wenigstens 2,5 mm² in der wenigstens einen innenliegenden Schicht aufweisen oder, wenn eine der Versorgungsleitung auf mehrere innenliegende Schichten verteilt angeordnet ist, die betreffende Versorgungsleitung in der Summe insgesamt einen Leitungsquerschnitt von wenigstens 2,5 mm² aufweist.

3. Leuchte nach einem der vorhergehenden Ansprüche, wobei wenigstens eine der Versorgungsleitungen eine Schichtdicke von wenigstens 400 µm entlang einer Richtung senkrecht zu der mit den LEDs (6) besetzten Oberfläche (5) und senkrecht zu der mit dem LED-Treiber besetzten Oberfläche (4) aufweist, oder wenn eine der Versorgungsleitung auf mehrere innenliegende Schichten verteilt angeordnet ist, die betreffende Versorgungsleitungen in den mehrere innenliegende Schichten jeweils Schichtstärken zwischen 20 µm und 200 µm aufweisen und in der Summe insgesamt eine Schichtdicke von wenigstens 400 µm bilden.

4. Leuchte nach einem der vorhergehenden Ansprüche, wobei eine oder zwei Stirnseiten der Leiterplatte mit mehrpoligen Steckverbindern ausgestattet sind, welche dafür eingerichtet sind, die elektrische Kontaktstellen zwischen den Versorgungsleitungen der Leuchte und Versorgungsleitung einer benachbarten Leuchte zu bilden, wobei die Steckkontakte insbesondere als THT (Through Hole Technology) oder SMT (Surface Mounted Technology) ausgebildet sind.

5. Leuchte nach einem der vorhergehenden Ansprüche, wobei parallel zu den Versorgungsleitungen weitere Leiterbahnen (3) in der wenigstens einen innenliegenden Schicht der Leiterplatte Steuerleitungen bilden, welche zur Steuerung des LED-Treibers oder einer oder mehreren der LEDs (6) eingerichtet sind, wobei die Steuerleitungen insbesondere durch DALI (Digital Addressable Lighting Interface)-Busleitungen gebildet sind.

6. Leuchte nach Anspruch 5, wobei die Steuerleitungen der Leuchte mit Steuerleitungen einer benachbarten Leuchte verbindbar sind, insbesondere durch eine mehrpolige Steckverbindung an der Leiterplatte verbindbar sind.

7. Leuchte nach Anspruch 5 oder 6, wobei die Leuchte auf einer der Oberflächen (4, 5) der Leiterplatte wenigstens einen Signalverstärker aufweist, welcher dafür eingerichtet ist, das Signal der Steuerleitungen zu verstärken.

8. Leuchte nach einem der vorhergehenden Ansprüche, wobei mehrere versetzt zueinander angeordneten Lödpads (1) auf wenigstens einer der genannten Oberflächen (4, 5) der Leiterplatte angeordnet sind und mittels der Durchgangskontaktierung (2) mit den Versorgungsleitungen in der innenliegenden Schicht der Leiterplatte und/oder bei Rückbezug auf einen der Ansprüche 5 bis 7 mit der wenigsten einen Signalleitung in einer innenliegenden Schicht der Leiterplatte elektrisch verbunden sind.

9. Leuchte nach Anspruch 8, wobei die LEDs (6) und/oder der LED-Treiber an ausgewählten Lötpads (1) direkt angelötet sind.

10. Leuchte nach einem der vorhergehenden Ansprüche, wobei die LEDs (6) in einem einheitlichen Abstand entlang wenigstens einer Längsrichtung der Leiterplatte bis zu zwei entgegengesetzten Rändern der Leiterplatte angeordnet sind, wobei die Abstände zu den Rändern der Leiterplatte so gewählt sind, dass Abstände der LEDs (6) zu einer benachbarten Leuchte gleicher Bauart kontinuierlich fortsetzbar sind.
